# EUROPÄISCHE PATENTSCHRIFT

(11) **EP 3 957 776 B1**
(45) Veröffentlichungstag und Bekanntmachung des Hinweises auf die Patenterteilung: **18.06.2025**
(21) Anmeldenummer: 20191322.5
(22) Anmeldetag: 17.08.2020
(51) Int. Cl.: C30B 25/12, C23C 16/458, C30B 25/18, C30B 29/06, H01L 21/66, C23C 16/52

(54) **VERFAHREN ZUM ABSCHEIDEN EINER EPITAKTISCHEN SCHICHT AUF EINER SUBSTRATSCHEIBE**
METHOD FOR DEPOSITING AN EPITAXIAL LAYER ON A SUBSTRATE WAFER
PROCÉDÉ DE DÉPÔT D'UNE COUCHE ÉPITAXIÉE SUR UNE TRANCHE DE SUBSTRAT

(43) Veröffentlichungstag der Anmeldung: 23.02.2022
(73) Patentinhaber: Siltronic AG, 81677 München (DE)
(72) Erfinder: Stettner, Thomas, 83329 Waging am See (DE); Wengbauer, Martin, 84543 Winhöring (DE)
(74) Vertreter: Staudacher, Wolfgang

(56) Entgegenhaltungen:
- WO-A1-2014/103657
- JP-A- 2002 043 230
- GHIM YOUNG-SIK ET AL: "Reflectometry-based wavelength scanning interferometry for thickness measurements of very thin wafers", OPTICS EXPRESS, vol. 18, no. 7, 29 March 2010 (2010-03-29), US, pages 6522, XP055938792, ISSN: 2161-2072, DOI: 10.1364/OE.18.006522
- GRIESMANN ULF ET AL: "Manufacture and Metrology of 300 mm Silicon Wafers with Ultra-Low Thickness Variation", AIP CONFERENCE PROCEEDINGS, vol. 931, 1 January 2007 (2007-01-01), NEW YORK, US, pages 105 - 110, XP055938943, ISSN: 0094-243X, Retrieved from the Internet <URL:https://doi.org/10.1063/1.2799352?locatt=mode:legacy> DOI: 10.1063/1.2799352

## Beschreibung

Gegenstand der Erfindung ist ein Verfahren zum Abscheiden einer epitaktischen Schicht auf einer Substratscheibe.

### Stand der Technik / Probleme

Für anspruchsvolle Anwendungen in der elektronischen Industrie werden epitaktisch beschichtete Halbleiterscheiben, insbesondere Substratscheiben aus einkristallinem Silizium benötigt, die mit einer Schicht aus Silizium epitaktisch beschichtet sind.

Ein häufig verwendetes Verfahren zum Abscheiden der Schicht stellt die Gasphasenabscheidung dar. Das Material für die Schicht wird dabei von Prozessgas bereitgestellt, das über die zu beschichtende Seite der Substratscheibe bei Temperaturen geleitet wird, bei denen sich eine im Prozessgas enthaltene Vorläuferverbindung, die das Material enthält, chemisch spaltet. Die Substratscheibe liegt während des Abscheidens der Schicht in der Tasche (pocket) eines Suszeptors, währenddessen sie von einer ringförmigen Begrenzung des Suszeptors umgeben ist. Das Verfahren wird in der Regel in einer Vorrichtung durchgeführt, die als Einzelscheibenreaktor ausgeführt ist. Ein solcher Einzelscheiben-Reaktor ist beispielsweise in EP 0 870 852 A1 beschrieben.

Damit die epitaktische Schicht möglichst gleichmäßig auf der Substratscheibe wächst, besteht ein besonderes Interesse daran, dass die Substratscheibe zentrisch zur Begrenzung in der Tasche liegt.

In US 2010 0216261 A1 wird vorgeschlagen, die korrekte Lage der Substratscheibe auf dem Suszeptor mittels eines Kamerasystems zu überwachen.

In WO17 135 604 A1 wird beschrieben, nach dem Abscheiden der epitaktischen Schicht einen Dickenkennwert im Randbereich zu messen und in Abhängigkeit des Messergebnisses bestimmte Prozess-Parameter für nachfolgende Abscheidevorgänge zu ändern.

WO 14 103 657 A1 und JP2015 201 599 A offenbaren Verfahren, die ausgehend von der Verteilung von Dickenkennwerten im Randbereich der Halbleiterscheibe mit epitaktisch abgeschiedener Schicht eine Exzentrizität berechnet, um in Abhängigkeit von dieser Exzentrizität die Lage einer nachfolgenden Substratscheibe auf dem Suszeptor zu korrigieren.

US2009 252 942 A1 und JP2002 043 230 A schlagen vor, die Ebenheit der Substratscheibe vor dem Abscheiden der epitaktischen Schicht zu messen und während des Abscheidens bestimmte Prozess-Parameter so zu ändern, dass mit dem Beschichten der Substratscheibe ein Randabfall geringer wird.

Allerdings lassen sich Dickenunterschiede im Randbereich der epitaktisch beschichteten Substratscheibe mit dieser Vorgehensweise nicht vermeiden, wenn die Substratscheibe selbst schon Dickenunterschiede im Randbereich aufweist.

Aufgabe der Erfindung ist es, eine Lösung des Problems anzubieten, die ermöglicht, die Dicke der epitaktischen Schicht im Randbereich an unterschiedlichen Positionen des Umfangs der Substratscheibe unterschiedlich einzustellen.

Die Aufgabe der Erfindung wird gelöst durch ein Verfahren zum Abscheiden einer epitaktischen Schicht auf einer Substratscheibe aus einer Gasphase, umfassend das Messen einer Randgeometrie der Substratscheibe, die einem Rand der Substratscheibe in Abhängigkeit von Randpositionen einen Dickenkennwert zuweist, wobei die Substratscheibe einen dickeren Randabschnitt und einen dünneren Randabschnitt aufweist, die sich gegenüberliegen;
das Ablegen der Substratscheibe in eine Tasche eines Suszeptors einer Vorrichtung zum Abscheiden der epitaktischen Schicht, wobei die Tasche von einer Begrenzung mit kreisförmigem Umfang umgeben ist;
das Erhitzen der Substratscheibe; und
das Leiten von Prozessgas über die Substratscheibe;
gekennzeichnet durch
das Ablegen der Substratscheibe in die Tasche derart, dass ein Abstand, den die Substratscheibe zur Begrenzung der Tasche hat, an Randpositionen des dickeren Randabschnitts mit größerem Dickenkennwert kleiner ist, als an Randpositionen des dünneren Randabschnitts mit kleinerem Dickenkennwert,
wobei der Dickenwert entweder der gemäß der SEMI-Norm M68-0720 definierte ZDD der Vorderseite, oder der gemäß der SEMI-Norm M67-0720 definierte ESFQR ist.

Der Erfindung liegt die Erkenntnis zugrunde, dass das zentrierte Ablegen der Substratscheibe in der Tasche mit der Erwartung einhergeht, dass die Substratscheibe eine einheitliche Randgeometrie besitzt. In der Praxis ist das jedoch eher selten der Fall, weil Bearbeitungsschritte wie Schleifen und Polieren nicht in der Lage sind, eine Substratscheibe mit vollständig einheitlicher Randdicke zu schaffen. Das erfindungsgemäße Verfahren ist in der Lage, die Randgeometrie einer epitaktisch beschichteten Halbleiterscheibe im Vergleich zur unbeschichteten Substratscheibe zu vereinheitlichen, insbesondere, wenn die Substratscheibe in einem Randabschnitt eine vergleichsweise niedrige Randdicke besitzt und im gegenüberliegenden Randabschnitt eine vergleichsweise hohe Randdicke. Ungeachtet dessen kann auch eine Homogenisierung der Randdicke erreicht werden, wenn beispielsweise nur ein Randabschnitt mit vergleichsweise niedriger Randdicke vorhanden ist.

Zunächst wird die Randgeometrie der Substratscheibe gemessen, so dass sie in Form eines Dickenkennwerts zur Verfügung steht. Vorzugsweise wird ein äußerstes Randstück mit einer radialen Länge von 1 mm oder 2 mm als Randausschluss (edge exclusion) von der Messung ausgenommen. Als Dickenkennwert kommt prinzipiell jeder Messwert in Frage, der eine Aussage über die relative Dicke an zwei unterschiedlichen Abschnitten im Randbereich der Substratscheibe zu machen erlaubt. Erfindungsgemäß eignet sich als Dickenkennwert der ZDD (Z double derivative) der Vorderseite, der die Krümmung des Randabfalls beschreibt und in der SEMI-Norm M68-0720 definiert ist, oder der ESFQR, der die Ebenheit von Sektoren (sites) im Randbereich quantifiziert und in der SEMI-Norm M67-0720 definiert ist. Die weitere Beschreibung verwendet stellvertretend ESFQR als Dickenkennwert.

Das erfindungsgemäße Verfahren sieht vor, die Randgeometrie einer Substratscheibe vor deren Beschichtung mit einer epitaktischen Schicht zu messen. Danach liegt beispielsweise eine Karte vor, die jedem Sektor einen ESFQR-Wert zuordnet und damit ein Dickenprofil der Substratscheibe entlang von deren Umfang anzeigt. Substratscheiben mit einer keilartigen Form des Querschnitts oder solche, die an einem Randabschnitt dünner sind als an anderen sind besonders geeignet. Mit Randabschnitt ist ein Randbereich gemeint, der sich über eine Strecke von bis zu 50 % des Umfangs, vorzugsweise 7 % bis 42 % des Umfangs in Umfangsrichtung erstreckt. Eine Substratscheibe mit keilartiger Form hat einen dickeren Randabschnitt und einen dünneren Randabschnitt, die sich gegenüberliegen, also den größtmöglichen Abstand zueinander haben.

Für die zur Beschichtung der Substratscheibe zum Einsatz kommende Abscheidekammer, einen Einzelscheiben-Reaktor, wird eine Korrelations-Funktion erstellt, die einem Verschiebevektor einen Dickenkennwert zuordnet. Der Verschiebevektor zeigt die Richtung und den Betrag an, um den die Substratscheibe mit dem dickeren Randabschnitt aus der zentrierten Lage versetzt in die Tasche des Suszeptors gelegt werden muss, damit auf dem gegenüberliegenden dünneren Randabschnitt beim Abscheiden der epitaktischen Schicht mehr Material abgeschieden wird, als auf dem dickeren Randabschnitt. Dementsprechend ist der Dickenkennwert nach der Abscheidung im dünneren Randabschnitt der Substratscheibe um den zugeordneten Dickenkennwert größer, als er nach der Abscheidung einer epitaktischen Schicht wäre, im Verlauf derer die Substratscheibe zentriert in der Tasche des Suszeptors liegt. Der Verschiebevektor repräsentiert also eine Exzentrizität der Lage des Mittelpunkts der auf dem Suszeptor liegenden Substratscheibe im Vergleich zur Lage, die der Mittelpunkt hätte, läge die Substratscheibe zentriert in der Tasche des Suszeptors. Die Korrelations-Funktion wird vor der Beschichtung der Substratscheibe durch Versuche ermittelt, indem festgestellt wird, welche Exzentrizität welche Änderung des Dickenkennwerts zur Folge hat.

Das Ablegen der Substratscheibe in die Tasche des Suszeptors erfolgt zweckmäßigerweise durch einen Roboter, der das nach Vorgabe der Korrelations-Funktion ausführt. Alternativ oder ergänzend kann der Roboter als selbstlernendes System konfiguriert sein, das mit den gemessenen Geometriedaten der Substratscheiben und der resultierenden epitaktisch beschichteten Halbleiterscheiben die nötige Exzentrizität für die Beschichtung nachfolgender Substratscheiben ermittelt und umsetzt. Darüber hinaus ist bevorzugt, die Ablage der Substratscheibe auf dem Suszeptor und deren Lage in der Tasche des Suszeptors mittels eines Kamerasystems zu überwachen.

Die Substratscheibe und die darauf abgeschiedene epitaktische bestehen vorzugsweise im Wesentlichen aus Halbleitermaterial, beispielsweise aus einkristallinem Silizium. Die Substratscheibe hat vorzugsweise einen Durchmesser von mindestens 200 mm, besonders bevorzugt mindestens 300 mm. Die epitaktische Schicht hat vorzugsweise eine Dicke von 1 µm bis 20 µm.

Die Erfindung wird nachfolgend mit Verweis auf Zeichnungen näher beschrieben.

### Kurzbeschreibung der Figuren

**Fig. 1** zeigt qualitativ auf, wie die Erfindung wirkt.
**Fig. 2** zeigt eine erfindungsgemäß in der Tasche des Suszeptors abgelegte Substratscheibe.
**Fig. 3** zeigt eine Korrelations-Funktion, die einer Exzentrizität E eine zu erwartende Änderung eines Dickenkennwerts zuordnet.
**Fig. 4** zeigt die Abweichung der Dicke einer Substratscheibe von einer Zieldicke entlang von deren Durchmesser
**Fig. 5** zeigt die Abweichung der Dicke der epitaktisch beschichteten Substratscheibe gemäß Fig.4 von einer Zieldicke entlang des Durchmessers der epitaktisch beschichteten Substratscheibe
**Fig. 6** zeigt die Abweichung der Dicke der epitaktischen Schicht der beschichteten Substratscheibe gemäß Fig. 5 von einer Zieldicke entlang des Durchmessers der epitaktischen Schicht.
**Fig. 7** zeigt den Verlauf der Abweichung des Dickenkennwerts von einem Zielwert entlang des Umfangs einer Substratscheibe vor und nach dem Abscheiden einer epitaktischen Schicht.

### Liste der verwendeten Bezugszeichen

- **1**: Substratscheibe
- **2**: epitaktische Schicht
- **3**: Suszeptor
- **4**: Tasche
- **5**: dicker Randabschnitt der Substratscheibe
- **6**: dünner Randabschnitt der Substratscheibe
- **7**: äußere Begrenzung der Tasche
- **8**: Karte
- **E**: Exzentrizität
- **ESFQR**: ESFQR-Wert
- Δ**ESFQR**: Unterschied des ESFQR-Werts zum Zielwert
- **Δt**: Unterschied der Dicke t zur Zieldicke
- **d**: Durchmesser
- **WP**: Randposition

### Detaillierte Beschreibung erfindungsgemäßer Ausführungsbeispiele

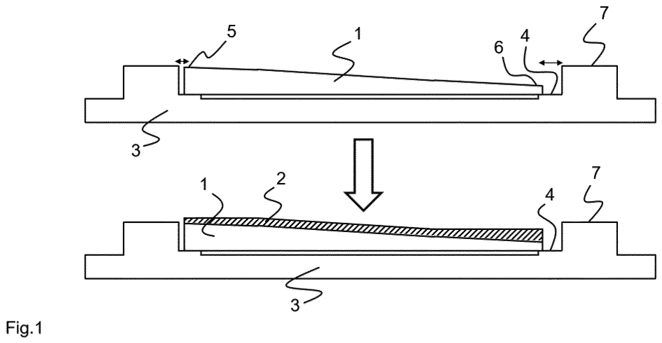

Fig.1 zeigt in Schnittdarstellung (Vertikalschnitt) eine in der Tasche 4 eines Suszeptors 3 abgelegte Substratscheibe 1, die einen Randabschnitt 5 aufweist, der vergleichsweise dick ist, und einen gegenüberliegenden Randabschnitt 6, der vergleichsweise dünn ist. Die Substratscheibe 1 liegt nicht zentriert in der Tasche 4, sondern exzentrisch und zwar so, dass der dickere Randabschnitt 5 einen kleineren Abstand zu einer Begrenzung 7 der Tasche hat, als der dünnere Randabschnitt 6. Diese Konfiguration hat zur Folge, dass dort, wo der Abstand kleiner ist, die Geschwindigkeit des Aufwachsens von Material während des Abscheidens der epitaktischen Schicht geringer ist, als dort, wo der Abstand größer ist.

Der untere Teil von Fig.1 zeigt die Situation nach dem Abscheiden der epitaktischen Schicht 2. Aus der Substratscheibe 1 ist eine Substratscheibe mit abgeschiedener epitaktischer Schicht geworden, wobei die epitaktische Schicht 2 im Bereich des Randabschnitts mit kleinerem Abstand zur Begrenzung 4 dünner ist als im Bereich des Randabschnitts mit größerem Abstand zur Begrenzung 4. Wird die Dicke der Substratscheibe mit abgeschiedener epitaktischer Schicht 2 betrachtet und mit der Dicke der Substratscheibe 1 verglichen, stellt man fest, dass die Dicke der epitaktisch beschichteten Substratscheibe in deren Randbereich gleichmäßiger ist, als die Dicke der Substratscheibe 1. Die Dickenunterschiede im Randbereich sind im Fall der Substratscheibe 1 ausgeprägter, als im Fall der epitaktisch beschichteten Substratscheibe.

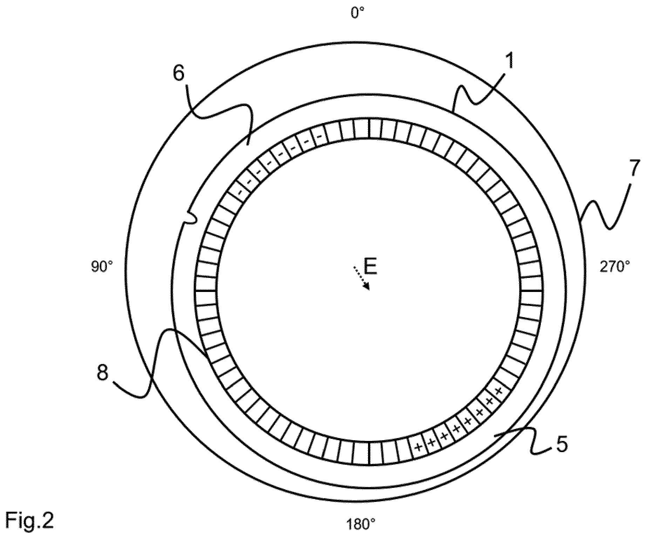

Fig. 2 zeigt in Draufsicht eine erfindungsgemäß in der Tasche des Suszeptors abgelegte Substratscheibe. Die Substratscheibe 1 liegt nicht zentrisch in der Tasche des Suszeptors. Der Mittelpunkt der Substratscheibe ist entsprechend der Exzentrizität E vom Mittelpunkt der Tasche verschoben und zwar so, dass der dickere Randabschnitt 6 einen kleineren Abstand zur äußeren Begrenzung 7 der Tasche hat, als der dünnere Randabschnitt 6. Richtung und Betrag der Exzentrizität E sind abhängig von einer Messung der Randgeometrie der Substratscheibe, beispielsweise indem in 5° breiten Randsegmenten die Ebenheit in Form des ESFQR-Werts gemessen wird. Das Ergebnis der Messung ist durch die eingezeichnete Karte 8 qualitativ angedeutet und weist den mit "+" - Symbolen hervorgehobenen dickeren Randabschnitt 5 und den mit "-" - Symbolen hervorgehobenen dünneren Randabschnitt 6 aus.

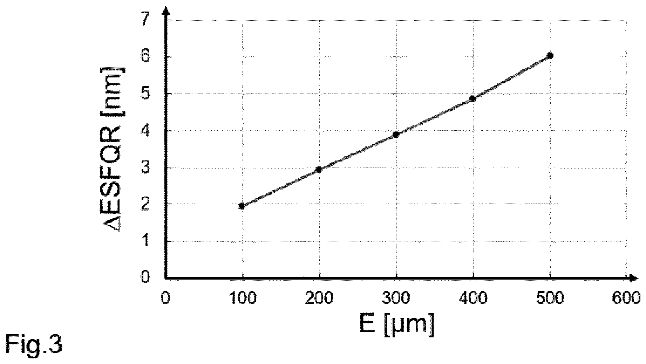

Die gewählte Exzentrizität E basiert auf einer Korrelations-Funktion, die durch Vorversuche für die zur Anwendung kommende Abscheidevorrichtung bestimmt wird. Dabei wird untersucht, welche Änderung des Dickenkennwerts zu erwarten ist, wenn die Substratscheibe mit einer bestimmten Exzentrizität E in der Tasche des Suszeptors abgelegt wird. Im ausgewählten Beispiel zeigt die Korrelations-Funktion gemäß Fig. 3 an, welcher Unterschied ΔESFQR des ESFQR-Werts im dünneren Randabschnitt nach der Abscheidung erhalten wird, wenn die Substratscheibe vor der Abscheidung nicht zentrisch, sondern mit der entsprechenden Exzentrizität E in die Tasche des Suszeptors abgelegt wird. Die Korrelations-Funktion gemäß Fig. 3 lässt also erwarten, dass nach dem Abscheiden der epitaktischen Schicht der ESFQR-Wert in den Sektoren des dünneren Randabschnitts um etwa 2 nm größer sein wird, sofern die Substratscheibe vor dem Abscheiden nicht zentrisch, sondern mit einer Exzentrizität von 100 µm in der Tasche des Suszeptors abgelegt wurde.

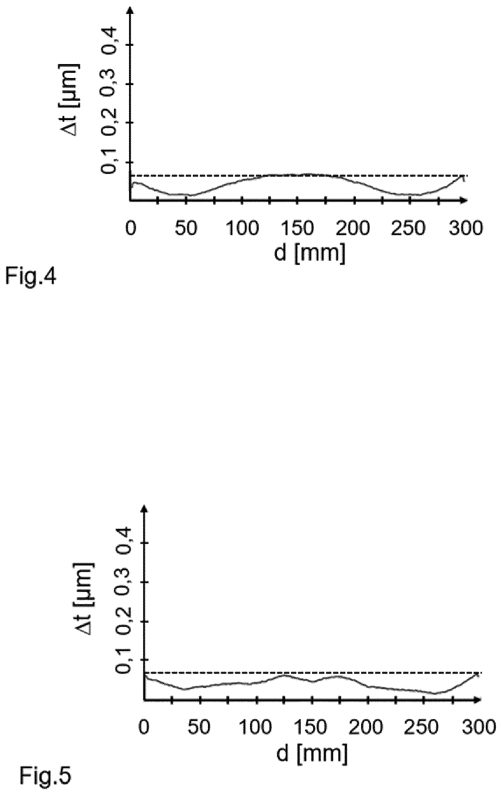

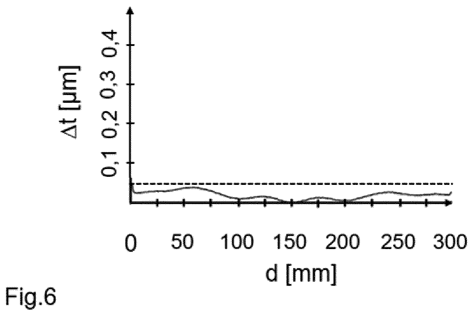

Fig. 4, Fig. 5 und Fig. 6 zeigen jeweils den Verlauf der Abweichung einer Dicke von einer Zieldicke einer Substratscheibe aus einkristallinem Silizium vor (Fig. 4) und nach (Fig. 5) dem Abscheiden einer epitaktischen Schicht sowie die Abweichung der Dicke der epitaktischen Schicht (Fig. 6) von einer Zieldicke. Gemäß Fig. 4 hatte die Substratscheibe deutlich unterschiedliche Randdicken, mit einem dünneren Randabschnitt im Bereich von 0 mm und einem dickeren Randabschnitt im Bereich von 300 mm. Nach dem Abscheiden der epitaktischen Schicht entsprechend der vorliegenden Erfindung war der Unterschied der Randdicken in diesen Randabschnitten nahezu ausgeglichen (Fig. 5). Der Verlauf der Dickenabweichung der epitaktischen Schicht gemäß Fig. 6 zeigt, dass die epitaktische Schicht wegen des Anwendens des erfindungsgemäßen Verfahrens an derjenigen Randposition dicker ist, die dem dünneren Randabschnitt der Substratscheibe entspricht, und an derjenigen Randposition dünner ist, die dem dickeren Randabschnitt der Substratscheibe entspricht. Die exzentrische Lage der Substratscheibe hat bewirkt, dass an den betrachteten Randabschnitten unterschiedlich viel Material abgeschieden wurde.

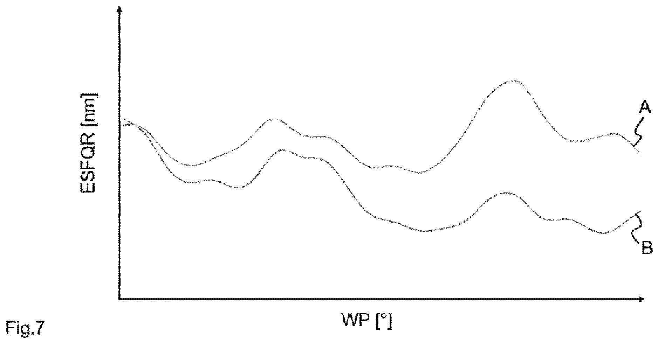

Das erfindungsgemäße Vorgehen verbessert die Randgeometrie, auch wenn sie über den gesamten Umfang betrachtet wird. Fig. 7 zeigt in Form von geglätteten Kurven die Randgeometrie einer Substratscheibe vor (Kurve A) und nach (Kurve B) dem Abscheiden einer epitaktischen Schicht und zwar in Form des ESFQR-Werts in Abhängigkeit von der Randposition WP. Die Kurven basieren auf 72 Messpunkten, von denen jeder den ESFQR-Wert eines Sektors mit einer Breite von 5 ° und einer radialen Länge von 35 mm beschreibt, wobei ein Randausschluss von 1 mm berücksichtigt ist.

Die vorstehende Beschreibung beispielhafter Ausführungsformen ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren.

## Patentansprüche

1. Verfahren zum Abscheiden einer epitaktischen Schicht auf einer Substratscheibe aus einer Gasphase, umfassend
das Messen einer Randgeometrie der Substratscheibe, die einem Rand der Substratscheibe in Abhängigkeit von Randpositionen einen Dickenkennwert zuweist, wobei die Substratscheibe einen dickeren Randabschnitt und einen dünneren Randabschnitt aufweist, die sich gegenüberliegen;
das Ablegen der Substratscheibe in eine Tasche eines Suszeptors einer Vorrichtung zum Abscheiden der epitaktischen Schicht, wobei die Tasche von einer Begrenzung mit kreisförmigem Umfang umgeben ist;
das Erhitzen der Substratscheibe; und
das Leiten von Prozessgas über die Substratscheibe;
**gekennzeichnet durch**
das Ablegen der Substratscheibe in die Tasche derart, dass ein Abstand, den die Substratscheibe zur Begrenzung der Tasche hat, an Randpositionen des dickeren Randabschnitts mit größerem Dickenkennwert kleiner ist, als an Randpositionen des dünneren Randabschnitts mit kleinerem Dickenkennwert, wobei der Dickenwert entweder der gemäß der SEMI-Norm M68-0720 definierte ZDD der Vorderseite, oder der gemäß der SEMI-Norm M67-0720 definierte ESFQR ist.

2. Verfahren nach Anspruch 1, **gekennzeichnet durch** das Ablegen der Substratscheibe mittels eines Roboters.

3. Verfahren nach Anspruch 1 oder 2, **gekennzeichnet durch** das Überwachen der Lage der Substratscheibe in der Tasche mittels eines Kamerasystems.

4. Verfahren nach einem der Ansprüche 1 bis 3, **gekennzeichnet durch** das Abscheiden einer epitaktischen Schicht aus Silizium auf einer Substratscheibe aus einkristallinem Silizium.

## Claims

1. Method for depositing an epitaxial layer on a substrate wafer from a vapour phase, comprising measuring an edge geometry of the substrate wafer that assigns a thickness characteristic value to an edge of the substrate wafer as a function of edge positions, the substrate wafer having a thicker edge section and a thinner edge section which are opposite each other;
placing the substrate wafer in a pocket of a susceptor of a device for depositing the epitaxial layer, the pocket being surrounded by a boundary with a circular circumference;
heating the substrate wafer; and
passing process gas over the substrate wafer;
**characterized by**
placing the substrate wafer in the pocket such that the distance from the substrate wafer to the boundary of the pocket is smaller at edge positions of the thicker edge section with greater thickness characteristic value than at edge positions of the thinner edge section with smaller thickness characteristic value, wherein the thickness value is either the ZDD of the front side as defined according to the SEMI standard M68-0720 or the ESFQR as defined according to the SEMI standard M67-0720.

2. Method according to Claim 1, **characterized by** placing the substrate wafer by means of a robot.

3. Method according to Claim 1 or 2, **characterized by** monitoring the position of the substrate wafer in the pocket by means of a camera system.

4. Method according to any one of Claims 1 to 3, **characterized by** depositing an epitaxial layer of silicon on a single-crystal silicon substrate wafer.

## Revendications

1. Procédé de dépôt d'une couche épitaxiale sur une tranche de substrat à partir d'une phase gazeuse, comprenant
la mesure d'une géométrie du bord de la tranche de substrat, qui attribue une valeur d'épaisseur à un bord de la tranche de substrat en fonction de positions de bord, la tranche de substrat présentant une partie de bord plus épaisse et une partie de bord plus mince qui se font face ;
le placement de la tranche de substrat dans une poche d'un suscepteur d'un dispositif destiné au dépôt de la couche épitaxiale, la poche étant entourée d'une délimitation ayant un périmètre circulaire ;
le chauffage de la tranche de substrat ; et
le passage de gaz de processus sur la tranche de substrat ;
**caractérisé par**
le placement de la tranche de substrat dans la poche de façon telle qu'un espacement que présente la tranche de substrat par rapport à la délimitation de la poche est plus court aux positions de bord de la partie de bord plus épaisse à plus grande valeur d'épaisseur qu'aux positions de bord de la partie de bord plus mince à plus faible valeur d'épaisseur, la valeur d'épaisseur étant soit la ZDD, définie selon la norme SEMI M68-0720, de la face avant, soit le ESFOR défini selon la norme SEMI M67-0720.

2. Procédé selon la revendication 1, **caractérisé par** le placement de la tranche de substrat au moyen d'un robot.

3. Procédé selon la revendication 1 ou 2, **caractérisé par** la surveillance de la position de la tranche de substrat dans la poche au moyen d'un système de caméra.

4. Procédé selon l'une quelconque des revendications 1 à 3, **caractérisé par** le dépôt d'une couche épitaxiale de silicium sur une tranche de substrat en silicium monocristallin.
